# EUROPÄISCHE PATENTSCHRIFT

(11) **EP 3 571 705 B1**
(45) Veröffentlichungstag und Bekanntmachung des Hinweises auf die Patenterteilung: **30.03.2022**
(21) Anmeldenummer: 18700049.2
(22) Anmeldetag: 03.01.2018
(51) Int. Cl.: H01H 47/00, H01H 50/12

(54) **RELAISANORDNUNG MIT VERBESSERTER ENTWÄRMUNG UND WANDLERVORRICHTUNG MIT EINER SOLCHEN RELAISANORDNUNG**
RELAY ARRANGEMENT WITH IMPROVED HEAT DISSIPATION AND CONVERTER DEVICE HAVING A RELAY ARRANGEMENT OF THIS KIND
ENSEMBLE RELAIS À EXTRACTION THERMIQUE AMÉLIORÉE ET ENSEMBLE CONVERTISSEUR ÉQUIPÉ D'UN TEL ENSEMBLE RELAIS

(30) Priorität: 23.01.2017 DE 102017101236
(43) Veröffentlichungstag der Anmeldung: 27.11.2019
(73) Patentinhaber: SMA Solar Technology AG, 34266 Niestetal (DE)
(72) Erfinder: PAPENFUSS, Frank, 34329 Nieste (DE); BETHKE, Lars, 37083 Göttingen (DE); GEHRKE, Christian, 34127 Kassel (DE); KUEHN, Thomas, 34414 Warburg (DE)
(74) Vertreter: Lahnor, Peter
(86) Internationale Anmeldenummer: PCT/EP2018/050138
(87) Internationale Veröffentlichungsnummer: WO 2018/134050

(56) Entgegenhaltungen:
- EP-A1- 0 465 693
- EP-A1- 2 228 895
- DE-T5-112014 005 941

## Beschreibung

Die Erfindung bezieht sich auf eine Relaisanordnung mit verbesserter Entwärmung und eine Wandlervorrichtung mit einer solchen Relaisanordnung und dient damit insbesondere der Verbesserung der Abführung der im Betrieb der Relais entstehenden Wärme.

Eine erfindungsgemäße Relaisanordnung weist mindestens zwei in Reihe geschaltete Relais auf. Solche Relaisanordnungen können bei Wandlervorrichtungen, wie beispielsweise Wechselrichtern, in Form einer Netztrennstelle Verwendung finden. Wechselrichter, die beispielsweise Energie aus dezentralen, regenerativen Quellen in ein Verbundnetz einspeisen, müssen im Falle einer Störung des Verbundnetzes sicher vom Netz getrennt werden können, um Personen, die an der Behebung der Störung arbeiten, nicht zu gefährden. Aus diesem Grund existieren Vorschriften, dass solche Netztrennstellen einfehlersicher auszuführen sind, was bedeutet, dass auch bei Ausfall eines Relais die Verbindung sicher getrennt werden kann. Deshalb werden oft pro Netzzuleitungspfad zwei Relais oder bei größeren Anlagen Schütze in Reihe geschaltet, so dass bei einem Defekt eines Relais das in Reihe geschaltete zweite die Netztrennung durchführen kann.

Bei elektronischen Bauteilen, wie beispielsweise Halbleiterschaltern, ist bekannt, dass sie bei ihrem Betrieb eine erhebliche Verlustleistung produzieren. Aus diesem Grund sind Halbleiterschalter oft auf Kühlkörpern aufgebracht oder man verwendet Lüfter, um einen kühlenden Luftstrom längs der Bauteile zu führen, um die im Betrieb entstehende Wärme abzuleiten. Die zu erwartende maximale Verlustleistung ist in Datenblättern der jeweiligen elektronischen Bauteile angegeben. So können beispielsweise mit Simulationsmodellen für eine gewünschte Schaltungsanordnung die abzuleitende Wärmemenge berechnet bzw. simuliert werden.

Demgegenüber liegen für Relais solche Angaben bisher allenfalls als typische Werte vor. Weder Datenblätter noch "application notes" weisen auf die im Betrieb entstehende maximale Wärmeentwicklung hin. Im Rahmen der Erfindung wurden bei Relais im bestimmungsgemäßen Betrieb überraschend hohe Verlustleistungen ermittelt, welche die Relaisanordnung thermisch überlasten können, weshalb Kühlmaßnahmen in Betracht zu ziehen sind. Zudem möchte man aus Kostengründen oft auf recht kleine, leicht gebaute Relais mit daraus resultierend geringerer Stromtragfähigkeit zurückgreifen. Die Wärmeableiteigenschaften fallen dann durch eine wenig massive Ausführung der Komponenten bei kompakter Bauform noch geringer aus. Hieraus ergibt sich eine weitere Motivation, eine verbesserte Entwärmung von Relais zu schaffen.

Im Stand der Technik bekannt sind Stromschienen auf denen beispielsweise Halbleitermodule aufgebracht sind, die der Stromführung zu den Halbleitermodulen dienen und in einem flächigen thermischen Kontakt zu einer Kühleinrichtung stehen, wie beispielsweise in der DE 10 2004 018 469 B3 beschrieben. Die Kühlung selbst wird von einer sehr kompakten Kühleinrichtung übernommen, die zusammen mit den Stromschienen hier als Verschienungspaket bezeichnet wird. Die Halbleitermodule selbst umfassen Halbleiterschalter auf einem elektrisch leitenden Substrat, wobei das Substrat sowohl der elektrischen Kontaktierung als auch der thermischen Ankopplung des Halbleitermodules dient. Nachteilig ist hier, dass zur Stromführung und Wärmeableitung mehrere Komponenten erforderlich sind.

WO 2015/184546 A1 offenbart eine Stromschiene, auf die elektronische Schalter aufgebracht sind, und die in einer T-förmigen Konfiguration die Schalter mit einer Kühlungsanordnung verbindet. Auch hier sind verschiedene Komponenten für die Stromführung und die Wärmeableitung erforderlich.

Die EP 2 228 895 B1 offenbart eine Wechselrichterschaltung mit einer zwischen einem DC/AC-Wandler und einem Energieversorgungsnetz angeordneten Relaisschaltung, die drei zweipolige Relais aufweist, wobei jeweils nur ein Relaiskontakt eines Relais in Reihe mit einem Relaiskontakt eines der beiden anderen Relais (R2) verbunden ist.

Die EP 0 465 693 A1 betrifft einen elektrisch isolierenden Schaltungsträger mit von seiner Oberfläche abstehenden Elementen, die einstückig mit dem Schaltungsträger verbunden sind, wobei ein Teil der im Wesentlichen flächig ausgebildeten Elemente metallisierte Bahnen und/oder Flächen aufweist, die zur Abführung und Weiterleitung der Verlustwärme durch auf dem Schaltungsträger angeordnete und in Betrieb befindliche elektrische Bauelemente dienen.

Die DE 11 2014 005941 T5 betrifft eine Schaltungsstruktur, eine elektronische Komponente und eine Leiterplatte mit Leiterbahnen umfasst, wobei die elektronische Komponente auf der Leiterplatte montiert ist und ein Wärmeableitelement, auf dem die Leiterplatte 14 platziert ist, die Wärme von der Leiterplatte ableitet.

In Bezug auf Relais wurden bisher keine expliziten Entwärmungsmaßnahmen vorgeschlagen, da man von geringer Wärmeentwicklung ausging. So sollten geringe Wärmemengen beispielsweise über die Kontaktierung des Relais auf einer Hauptleiterplatte und den Wärmeübergang auf die auf der Hauptleiterplatte befindlichen Leiterbahnen ausreichen.

Die im Rahmen der Erfindung im Betrieb der Relais ermittelten höheren maximalen Kontaktwiderstände können jedoch zu einer thermischen Überlastung der Relaisanordnung führen, wenn diese nicht entsprechend dimensioniert wurde. Aufgabe der vorliegenden Erfindung ist es daher, eine Relaisanordnung mit verbesserter Entwärmung anzugeben, die kostengünstig ist, im Aufbau kompakt bleibt und mit möglichst wenigen zusätzlichen Bauteilen auskommt.

Eine erfindungsgemäße Relaisanordnung mit verbesserter Entwärmung weist mindestens zwei in Reihe geschaltete Relais auf, die über erste und zweite Anschlüsse mechanisch und elektrisch mit einer Hauptleiterplatte verbunden sind. Dabei sind mehrere voneinander isolierte flächige zur Stromführung jeweils zwischen den mindestens zwei in Reihe geschalteten Relais angeordnet, wobei die flächigen Leiter mechanisch mit der Hauptleiterplatte und elektrisch und thermisch mit den ersten Anschlüssen der Relais verbunden sind, um eine Abfuhr der beim Betrieb der Relais entstehenden Wärme zu bewirken. Die flächigen Leiter sollten dabei vorteilhafterweise sowohl gute elektrische Leiter, als auch gute Wärmeleiter sein. So könnten die flächigen Leiter beispielsweise aus Kupferblech gefertigt werden. Durch die flächige Ausführung kann sich beim Betrieb der Relais entstehende Wärme in den flächigen Leitern verteilen und an die Umgebung abgeführt werden.

Die erfindungsgemäße Relaisanordnung mehrere voneinander isolierte flächige Leiter auf, die zueinander räumlich parallel und benachbart angeordnet sind. Die mehreren voneinander isolierten flächigen Leiter verbinden jeweils elektrisch in Reihe geschaltete erste Anschlüsse mehrpoliger Relais oder mehrere erste Anschlüsse verschiedener Relais miteinander. Bei den mehreren voneinander isolierten flächigen Leitern kann es sich um laminierte Busbars, massivere Kupferbleche oder ähnliches handeln.

Die mehreren flächigen Leiter sind erfindungsgemäß als mehrlagige Leiterplatte ausgeführt. Bei mehrlagigen Leiterplatten, auch "Multilayer Board" genannt, sind im Gegensatz zur Standardplatine mit zwei Kupfer-Außenlagen im Kern noch weitere Kupfer-Lagen integriert.

Die Ausführung des flächigen Leiters als mehrlagige Leiterplatte hat den Vorteil, dass so mehrere flächige Leiter und die dazwischen benötigte Isolation gleichzeitig bereitgestellt werden. So kann für zwei in Reihe geschaltete Relais mit jeweils beispielsweise vier Schaltkontakten die elektrische Verbindung und die benötigte Entwärmung durch eine Leiterplatte mit mindestens vier Leiterbahnen als ein integrales Bauteil sichergestellt werden. Durch den besonders flachen Aufbau von mehrlagigen Leiterplatten ist ein guter Wärmeübergang von den ersten Anschlüssen der beispielsweise mehrpoligen Relais gewährleistet, da keine großen Distanzen zur thermischen Anbindung der mehreren ersten Anschlüsse an die mehrlagige Leiterplatte überwunden werden müssen.

In einer vorteilhaften Ausführungsform der erfindungsgemäßen Relaisanordnung ist die mehrlagige Leiterplatte im Wesentlichen senkrecht zur Ebene der Hauptleiterplatte angeordnet. Ein Bügel zur Lagefixierung der mehrlagigen Leiterplatte relativ zur Ebene der Hauptleiterplatte kann vorgesehen sein. Vorteilhaft kann in diesen Ausführungsformen ein Konvektionsluftstrom die Entwärmung der mehrlagigen Leiterplatte zusätzlich unterstützen.

In einer weiteren vorteilhaften Ausführungsform der erfindungsgemäßen Relaisanordnung werden die ersten Anschlüsse der Relais durch Anschlüsse des Relais gebildet, die gegenüber den zweiten Anschlüssen mit einem größerem Leitungsquerschnitt ausgeführt und mit einem feststehenden Arbeitskontakt des Relais direkt verbunden sind. Meist ist der feststehende Arbeitskontakt von Relais massiver ausgeführt als der bewegliche Arbeitskontakt. So kann ein guter Wärmeübergang durch eine enge Anbindung der flächigen Leiter an die Anschlüsse des Relais, die mit dem feststehenden Arbeitskontakt direkt verbunden sind, realisiert werden.

In einer weiteren vorteilhaften Ausführungsform der erfindungsgemäßen Relaisanordnung weist die mehrlagige Leiterplatte mindestens eine mittlere Kupferlage und zwei die mittlere Kupferlage umgebende äußere Kupferlagen auf. Dabei ist die mittlere Kupferlage mit einer Messeinrichtung verbunden, und die äußeren Kupferlagen sind mit denselben der ersten Anschlüsse verbunden. So wird der Strom von einem ersten Kontakt eines Relais zu dem dazu in Reihe geschalteten ersten Kontakt des anderen Relais über mindestens zwei Lagen der mehrlagigen Leiterplatte geführt, wobei sich zwischen diesen beiden zwei Lagen mindestens eine weitere Lage befindet.

In einer weiteren vorteilhaften Ausführungsform wird an der mittleren Kupferlage mittels der Messeinrichtung ein Zwischenpotential zwischen den mindestens zwei in Reihe geschalteten Relais ermittelt.

Die mittlere Kupferlage wird beispielsweise mit einer Spannungsmessung verbunden, wodurch über eine kapazitive Kopplung das elektrische Potential an dem Punkt zwischen den beiden in Reihe geschalteten Relais ermittelt werden kann. Da an dieser Stelle bei geschlossenem Kontakt von mindestens einem der Relais eine Wechselspannung anliegt, ist die kapazitive Kopplung von Vorteil, da mögliche Gleichspannungsanteile ausgeblendet werden. Durch gezieltes Schalten der beiden in Reihe geschalteten Relais und bei Kenntnis der Spannungsverhältnisse vor und hinter den beiden in Reihe geschalteten Relais können so durch Ermittlung der Spannungsverhältnisse an dem Verbindungspunkt zwischen den beiden in Reihe geschalteten Relais beide Relais auf Ihre korrekte Funktion hin überprüft werden.

Die Erfindung bezieht sich ferner auf eine Wandlervorrichtung mit mehreren Wechselrichterbrücken und einer Relaisanordnung gemäß einer der oben beschriebenen Ausführungsformen der erfindungsgemäßen Relaisanordnung als Netztrennstelle.

Wie weiter oben erläutert bestehen oft Vorschriften bezüglich Wandlervorrichtungen, die in ein Verbundnetz einspeisen, so dass diese im Falle einer Störung des Verbundnetzes sicher vom Netz getrennt werden können. Dazu werden oft pro Netzzuleitungspfad zwei Relais oder bei größeren Anlagen Schütze in Reihe geschaltet, so dass bei einem Defekt eines Relais das in Reihe geschaltete zweite die Netztrennung durchführen kann.

In einer vorteilhaften Ausführungsform der erfindungsgemäßen Wandlervorrichtung weist diese mehrere mehrphasige Wechselrichterbrücken auf. Die Ströme einer Phase der mehreren Wechselrichterbrücken, das heißt die jeweils gleichphasigen Ströme der einzelnen Wechselrichterbrücken, werden jeweils einzeln über Relaiskontakte der mindestens zwei in Reihe geschalteten Relais geführt. An einem der zweiten Anschlüsse der mindestens zwei in Reihe geschalteten Relais werden die Ströme einer Phase zu einem gemeinsamen Phasenanschluss zusammengeführt.

In einer weiteren vorteilhaften Ausführungsform der erfindungsgemäßen Wandlervorrichtung fließen die Ströme einer Phase der mehreren Wechselrichterbrücken über verschiedene Relaiskontakte desselben Relais.

Weist die erfindungsgemäße Wandlervorrichtung beispielsweise zwei dreiphasige Wechselrichterbrücken auf, existieren zwei Ausgangsleitungen von Phase 1 (analog für Phase 2 und 3). Diese zwei Ausgangsleitungen können einzeln beispielsweise über zwei in Reihe geschaltete zweipolige Relais geführt werden. An einem netzseitigen Ausgang des zweiten Relais können die zwei Ausgangsleitungen zusammengeführt und als eine Ausgangsleitung dem Netzanschluss der Wandlervorrichtung zugeführt werden.

In einer anderen vorteilhaften Ausführungsform der erfindungsgemäßen Wandlervorrichtung fließen die Ströme einer Phase der mehreren Wechselrichterbrücken über Relaiskontakte verschiedener Relais.

So kann in oben beschriebenem Beispiel jede der zwei Ausgangsleitungen beispielsweise über jeweils zwei in Reihe geschaltete einpolige Relais geführt werden und an einem der netzseitigen Ausgänge der vier einpoligen Relais zusammengeführt werden. Für zwei dreiphasige Wechselrichterbrücken können beispielsweise die drei Phasen einer Brücke jeweils über zwei in Reihe geschaltete dreipoliges Relais geführt, so dass vier dreipolige Relais benötigt werden oder die gleichen Phasen über zwei in Reihe geschaltete zweipolige Relais, so dass sechs zweipolige Relais benötigt werden.

Durch die Ausführung der oben beschriebenen Netztrennrelais in Form einer erfindungsgemäßen Relaisanordnung ergibt sich ein zugleich kompakter Aufbau, der durch die zuverlässige Entwärmung zu einem robusten und sicheren Betrieb der Wandlervorrichtung führt.

Die Erfindung wird nachfolgend anhand von Ausführungsbeispielen unter Heranziehung von Zeichnungen beschrieben, aus denen sich, in Zusammenschau mit den Merkmalen der Ansprüche, weitere Merkmale, Eigenschaften und Vorteile der Erfindung ergeben.

Es zeigen:
- Fig. 1: ein Ausführungsbeispiel einer erfindungsgemäßen Relaisanordnung,
- Fig. 2: eine perspektivische Darstellung des Ausführungsbeispiels nach Figur 1,
- Fig. 3: eine weitere Ausgestaltung einer erfindungsgemäßen Relaisanordnung,
- Fig. 4: eine vorteilhafte Ausgestaltung einer Netztrennstelle mit einer erfindungsgemäßen Relaisanordnung, sowie
- Fig. 5: eine weitere vorteilhafte Ausgestaltung einer Netztrennstelle mit einer erfindungsgemäßen Relaisanordnung.

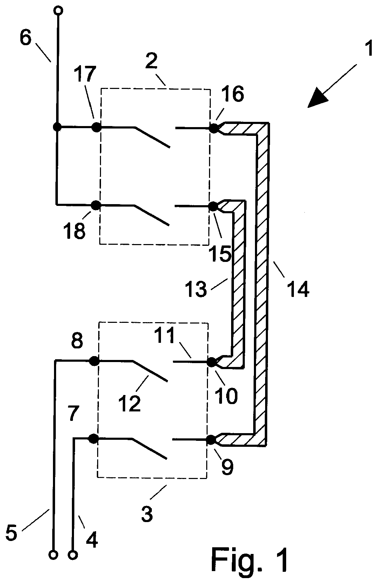

Fig. 1 zeigt ein Ausführungsbeispiel einer erfindungsgemäßen Relaisanordnung 1 mit zwei in Reihe geschalteten Relais 2, 3, wobei Eingangsanschlüsse 4, 5 einer elektronischen Schaltung (nicht gezeigt) an die zweiten Anschlüsse 7, 8 von Relais 3 herangeführt werden. Sind die Relaiskontakte 12, 11 geschlossen kann Strom von Anschluss 8 zu einem ersten Anschluss 10 von Relais 3 fließen. Der erste Anschluss 10 von Relais 3 wird über einen flächigen Leiter 13 mit dem ersten Anschluss 15 von Relais 2 in Reihe geschaltet. Über einen Schaltkontakt von Relais 2 und dessen zweiten Anschluss18 fließt der Strom weiter zum Ausgangsanschluss 6 der Relaisanordnung 1.

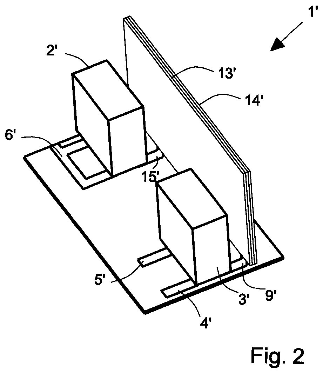

Der flächigen Leiter 13 stellt einerseits den elektrischen Kontakt zwischen den in Reihe geschalteten Relais 2, 3 her und dient durch seine flächige Ausgestaltung (siehe auch Figur 2) und die Wahl eines sowohl elektrisch als auch thermisch leitenden Materials der Abfuhr der beim Betrieb der Relais 2, 3 entstehenden Wärme.

Ganz analog wird der erste Anschluss 9 von Relais 3 wird über den flächigen Leiter 14 mit dem ersten Anschluss 16 von Relais 2 in Reihe geschaltet. Der über den anderen Schaltkontakt von Relais 2 zu dessen zweiten Anschluss 17 fließende Strom wird dort mit dem Strom von Anschluss 18 zusammengeführt, so dass die Ströme der Eingangsanschlüsse 4, 5 in einem Ausgangsanschluss 6 der Relaisanordnung 1 zusammengeführt werden. Auf diese Weise werden die Ströme von den Eingangsanschlüssen 4, 5 parallel über zwei Reihenschaltungen aus Relais geführt. So ist es möglich, kostengünstige Relais geringerer Stromtragfähigkeit zu verwenden und dennoch höhere Ströme sicher zu schalten und durch die verbesserte Entwärmung den stabilen und sicheren Betrieb zu gewährleisten.

Die flächigen Leiter 13, 14 verbinden die jeweils ersten Anschlüssen 9, 10, 15, 16 der Relais 2, 3, wobei die ersten Anschlüssen 9, 10, 15, 16 jeweils mit den feststehenden Kontakten, beispielsweise Kontakt 11 von Relais 3, verbunden sind. Im Gegensatz dazu sind die zweiten Anschlüsse 7, 8, 17, 18 der Relais 2, 3 mit den beweglichen Kontakten der Relais 2, 3, beispielsweise Kontakt 12 von Relais 3, verbunden. Meist ist der feststehende Arbeitskontakt der Relais massiver ausgeführt als der bewegliche Arbeitskontakt. So kann ein guter Wärmeübergang durch eine enge Anbindung der flächigen Leiter an die ersten Anschlüssen 9, 10, 15, 16 realisiert werden.

Fig. 2 zeigt eine perspektivische Darstellung des Ausführungsbeispiels nach Figur 1. Die Eingangsanschlüsse 4', 5' einer elektronischen Schaltung (nicht gezeigt) sind als Leiterbahnen auf einer Hauptleiterplatte (nicht gezeigt) ausgeführt. Die Relais 2', 3' sind in die Hauptleiterplatte eingelötet und dadurch elektrisch mit den Leiterbahnen und gleichzeitig mechanisch mit der Hauptleiterplatte selbst verbunden, so dass die Gehäuse der Relais 2', 3' senkrecht auf der Ebene der Hauptleiterplatte stehen.

Ebenso sind auch die flächigen Leiter 13', 14' senkrecht zur Ebene der Hauptleiterplatte angeordnet, wodurch die Abfuhr der beim Betrieb der Relais entstehenden Wärme begünstigt wird. Die flächigen Leiter 13', 14' können als laminierte Busbars mit einer elektrisch isolierenden Schicht dazwischen oder als mehrlagige Leiterplatte ausgeführt werden, die ebenso wie die Relais in die Hauptleiterplatte eingelötet werden.

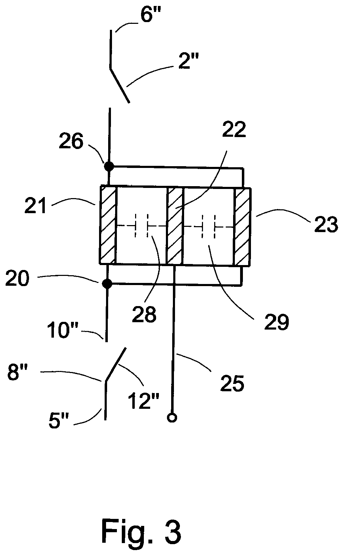

Fig. 3 zeigt eine weitere Ausgestaltung einer erfindungsgemäßen Relaisanordnung 1, wobei ein Eingangsanschluss 5" mit dem zweiten Anschluss 8" des Relais 12" verbunden ist. Bei geschlossenem Relais 12" fließt der Strom über den ersten Anschluss 10" des Relais 12" zu einem Anschlusspunkt 20, von dem aus sich der Strom auf zwei flächige Leiter 21, 23 oder zwei Leiterbahnen 21, 23 einer mehrlagigen Leiterplatte aufteilt. So kann eine weitere Wärmespreizung realisiert werden. Zwischen den Leiterbahnen 21, 23 befindet sich eine mittlere Leiterbahn 22, die über einen Anschlusspunkt 25 kontaktiert werden kann. Hier kann beispielsweise eine Messeinrichtung (nicht gezeigt) angeschlossen werden. Nach der Aufteilung des Stroms auf die zwei flächige Leiter 21, 23 oder zwei Leiterbahnen 21, 23 wird der Strom am Anschlusspunkt 26 wieder zusammengefasst, um den Relaiskontakt 2" zu passieren und dem Ausgangsanschluss 6" zugeführt zu werden.

Die äußeren Kupferlagen 21, 23 sind also mit demselben der ersten Anschlüsse des jeweiligen Relaiskontakte 12", 2" verbunden. Die innere Kupferlage 22 ist über virtuelle Kapazitäten 28, 29 mit den äußeren Kupferlagen 21, 23 gekoppelt, was heißt, dass diese Kapazitäten 28, 29 keine separaten Bauteile darstellen, sondern sich diese durch die parallele Anordnung der Kupferlagen intrinsisch ergeben.

Durch eine an den Anschlusspunkt 25 angeschlossene Messeinrichtung kann zusammen mit anderen im Stromverlauf vor und hinter den Relais angeordneten Messeinrichtungen die korrekte Funktion der Relaiskontakte 12", 2" geprüft werden.

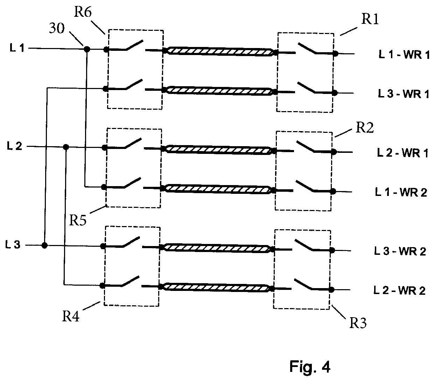

Fig. 4 zeigt eine vorteilhafte Ausgestaltung einer Netztrennstelle beispielsweise für eine Wandlervorrichtung mit mehreren Wechselrichterbrücken WR 1, WR 2 (nicht gezeigt). Die mehreren Wechselrichterbrücken WR 1, WR 2 formen einen dreiphasigen Strom der vor dem Ausgang der Wandlervorrichtung zusammengeführt wird, das heißt es handelt sich um parallele Wechselrichterbrücken, wobei der Strom für eine Phase des dreiphasigen Ausgansstromes durch jeweils zwei Wechselrichterbrücken geformt wird. Fig. 4 zeigt eine mögliche Aufteilung der Phasen eines dreiphasigen Ausgansstromes auf zweipolige Relais R1, R2, R3, R4, R5, R6. Der Strom für Phase L1 von den beiden Wechselrichterbrücken wird hier mit L1-WR 1 und L1-WR 2 bezeichnet und wird von den Wechselrichterbrücken kommend über jeweils eine erfindungsgemäßen Relaisanordnung gebildet von R1 und R6 sowie R2 und R5 geführt und an einem Ausgangsanschluss 30 zusammengeführt. Der jeweils andere Schaltkontakt der zweipoligen Relais wird von anderen Phasen oder anderen Wechselrichterbrücken genutzt. Der Strom für Phase L2 von den beiden Wechselrichterbrücken wird mit L2-WR 1 und L2-WR 2 bezeichnet und wird von den Wechselrichterbrücken kommend über jeweils eine erfindungsgemäßen Relaisanordnung gebildet von R2 und R5 sowie R3 und R4 geführt. Für L3 wird in diesem Beispiel die Kombination aus R3 und R4 sowie R1 und R6 genutzt. Das heißt, die jeweils gleichphasigen Ströme der einzelnen Wechselrichterbrücken werden einzeln über Relaiskontakte verschiedener Relais geführt. An einem der zweiten Anschlüsse der mindestens zwei in Reihe geschalteten Relais der erfindungsgemäßen Relaisanordnung werden die Ströme einer Phase zu einem gemeinsamen Phasenanschluss zusammengeführt.

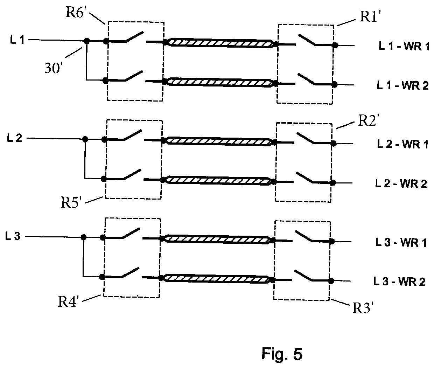

Fig. 5 zeigt eine weitere vorteilhafte Ausgestaltung einer Netztrennstelle mit einer erfindungsgemäßen Relaisanordnung, wobei eine andere Aufteilung der Phasen eines dreiphasigen Ausgansstromes auf zweipolige Relais R1', R2', R3', R4', R5', R6' gezeigt wird. Die Ströme für Phase L1 von den beiden Wechselrichterbrücken - wie in Fig. 4 mit L1-WR 1 und L1-WR 2 bezeichnet - werden von den Wechselrichterbrücken kommend über eine erfindungsgemäße Relaisanordnung gebildet von R1' und R6' geführt. Der Stromanteil L1-WR 1 von Wechselrichterbrücke 1 wird über einen Kontakt von Relais R1' und der zweite Stromanteil L1-WR 2 über den anderen Kontakt von Relais R1'und danach gemäß der erfindungsgemäßen Relaisanordnung über die beiden Kontakte des in Reihe geschalteten Relais R6' geführt. An dem zweiten Anschluss 30' des Relais R6' werden die Ströme der Phase L1 zusammengeführt.

### Bezugszeichenliste

- 1, 1': Relaisanordnung
- 2, 2', 2": Relais
- 3, 3': Relais
- 4, 4': Eingangsanschluss
- 5, 5', 5": Eingangsanschluss
- 6, 6', 6": Ausgangsanschluss
- 7: Anschluss
- 8, 8": Anschluss
- 9, 9': Anschluss
- 10, 10', 10": Anschluss
- 11: Kontakt
- 12, 12": Kontakt
- 13, 13': Leiter
- 14, 14': Leiter
- 15, 15': Anschluss
- 16: Anschluss
- 17: Anschluss
- 18: Anschluss
- 20: Anschlusspunkt
- 21: Leiter
- 22: Leiter
- 23: Leiter
- 25: Anschlusspunkt
- 26: Anschlusspunkt
- 28: Kapazität
- 29: Kapazität
- 30, 30': Anschluss
- L1, L2, L3: Phase
- L1-WR 1,...L3-WR 3: Phase

## Patentansprüche

1. Relaisanordnung (1) aufweisend
- mindestens zwei in Reihe geschaltete Relais (2, 3), die über erste Anschlüsse (9, 10, 15, 16) und zweite Anschlüsse (7, 8, 17, 18) mechanisch und elektrisch mit einer Hauptleiterplatte verbunden sind, die Relaisanordnung ist **gekennzeichnet durch**
- mehrere voneinander isolierte flächige Leiter (13, 14) zur Stromführung jeweils zwischen den mindestens zwei in Reihe geschalteten Relais (2, 3), wobei die flächigen Leiter (13, 14) mechanisch mit der Hauptleiterplatte und elektrisch und thermisch mit den ersten Anschlüssen (9, 10, 15, 16) der Relais (2, 3) verbunden sind um eine Abfuhr der beim Betrieb der Relais (2, 3) entstehenden Wärme zu bewirken, wobei die mehreren voneinander isolierten flächigen Leiter (13, 14) zueinander räumlich parallel und benachbart angeordnet sind, jeweils elektrisch in Reihe geschaltete erste Anschlüsse mehrpoliger Relais oder mehrere erste Anschlüsse verschiedener Relais miteinander verbinden und die mehreren flächigen Leiter (13, 14) als mehrlagige Leiterplatte ausgeführt sind.

2. Relaisanordnung nach Anspruch 1, wobei die mehrlagige Leiterplatte im Wesentlichen senkrecht zur Ebene der Hauptleiterplatte angeordnet ist.

3. Relaisanordnung nach Anspruch 1 oder 2, wobei ein Bügel zur Lagefixierung der mehrlagigen Leiterplatte relativ zur Ebene der Hauptleiterplatte vorgesehen ist.

4. Relaisanordnung nach einem der Ansprüche 1 bis 3, wobei die ersten Anschlüsse der Relais durch Anschlüsse der Relais gebildet werden, die gegenüber den zweiten Anschlüssen mit einem größerem Leitungsquerschnitt ausgeführt und mit einem feststehenden Arbeitskontakt des Relais direkt verbunden sind.

5. Relaisanordnung nach einem der vorhergehenden Ansprüche, wobei die mehrlagige Leiterplatte mindestens eine mittlere Kupferlage und zwei die mittlere Kupferlage umgebende äußere Kupferlagen aufweist, die mittlere Kupferlage mit einer Messeinrichtung verbunden ist und die äußeren Kupferlagen mit demselben der ersten Anschlüsse verbunden sind.

6. Relaisanordnung nach Anspruch 5, wobei an der mittleren Kupferlage mittels der Messeinrichtung ein Zwischenpotential zwischen den mindestens zwei in Reihe geschalteten Relais ermittelt wird.

7. Wandlervorrichtung mit mehreren Wechselrichterbrücken und einer Relaisanordnung nach einem der vorhergehenden Ansprüche als Netztrennstelle.

8. Wandlervorrichtung nach Anspruch 7, wobei Ströme einer Phase der mehreren Wechselrichterbrücken jeweils einzeln über Relaiskontakte der mindestens zwei in Reihe geschalteten Relais geführt und an einem der zweiten Anschlüsse der mindestens zwei in Reihe geschalteten Relais zu einem gemeinsamen Phasenanschluss zusammengeführt werden.

9. Wandlervorrichtung nach Anspruch 8, wobei die Ströme einer Phase der mehreren Wechselrichterbrücken über verschiedene Relaiskontakte desselben Relais fließen.

10. Wandlervorrichtung nach Anspruch 8, wobei die Ströme einer Phase der mehreren Wechselrichterbrücken über Relaiskontakte verschiedener Relais fließen.

## Claims

1. A relay arrangement (1) comprising
- at least two series-connected relays (2, 3), which are mechanically and electrically connected to a main printed circuit board via first terminals (9, 10, 15, 16) and second terminals (7, 8, 17, 18), the relay arrangement (1) is **characterized in**
- a plurality of flat conductors (13, 14), which are isolated from one another, for conducting current between the at least two series-connected relays (2, 3) each, wherein the flat conductors (13, 14) are mechanically connected to the main printed circuit board and electrically and thermally connected to the first terminals (9, 10, 15, 16) of the relays (2, 3) in order to effect dissipation of the heat produced during operation of the relays (2, 3), wherein the plurality of flat conductors (13, 14), which are isolated from one another, are arranged spatially parallel and adjacent to one another, and each connect electrically series-connected first terminals of multi-pole relays or a plurality of first terminals of different relays to one another, and wherein the plurality of flat conductors (13, 14) are embodied as a multilayer printed circuit board.

2. The relay arrangement as claimed in claim 1, wherein the multilayer printed circuit board is arranged substantially perpendicular to the plane of the main printed circuit board.

3. The relay arrangement as claimed in claim 1 or 2, wherein a bracket for fixing the position of the multilayer printed circuit board relative to the plane of the main printed circuit board is provided.

4. The relay arrangement as claimed in one of claims 1 to 3, wherein the first terminals of the relays are formed by terminals of the relays that are embodied with a larger line cross section compared to the second terminals and are connected directly to a stationary operating contact of the relay.

5. The relay arrangement as claimed in one of the preceding claims, wherein the multilayer printed circuit board has at least one central copper layer and two outer copper layers surrounding the central copper layer, the central copper layer is connected to a measuring device and the outer copper layers are connected to the same one of the first terminals.

6. The relay arrangement as claimed in claim 5, wherein an intermediate potential between the at least two series-connected relays is determined at the central copper layer by means of the measuring device.

7. A converter apparatus having a plurality of inverter bridges and a relay arrangement as claimed in one of the preceding claims as a grid disconnector.

8. The converter apparatus as claimed in claim 7, wherein currents of a phase of the plurality of inverter bridges are each individually conducted via relay contacts of the at least two series-connected relays and combined at one of the second terminals of the at least two series-connected relays to form a joint phase connection.

9. The converter apparatus as claimed in claim 8, wherein the currents of a phase of the plurality of inverter bridges flow via different relay contacts of the same relay.

10. The converter apparatus as claimed in claim 8, wherein the currents of a phase of the plurality of inverter bridges flow via relay contacts of different relays.

## Revendications

1. Arrangement de relais (1) comprenant
- au moins deux relais (2, 3) montés en série, qui sont reliés mécaniquement et électriquement à une carte imprimée principale par l'intermédiaire de premières bornes (9, 10, 15, 16) et de secondes bornes (7, 8, 17, 18), l'arrangement de relais étant **caractérisé par**
- plusieurs conducteurs plats (13, 14) isolés les uns des autres pour conduire le courant respectivement entre les au moins deux relais (2, 3) montés en série, les conducteurs plats (13, 14) étant reliés mécaniquement à la carte imprimée principale et électriquement et thermiquement aux premières bornes (9, 10, 15, 16) des relais (2, 3) afin d'assurer une dissipation de la chaleur produite lors du fonctionnement des relais (2, 3), les plusieurs conducteurs plats (13, 14) isolés les uns des autres étant disposés parallèlement les uns aux autres dans l'espace et au voisinage les uns des autres, reliant les uns aux autres les premières bornes de relais multipolaires montées électriquement en série ou plusieurs premières bornes de différents relais et les plusieurs conducteurs plats (13, 14) étant réalisés sous la forme d'une carte imprimée multicouche.

2. Arrangement de relais selon la revendication 1, dans lequel la carte imprimée multicouche est disposée sensiblement perpendiculairement au plan de la carte imprimée principale.

3. Arrangement de relais selon la revendication 1 ou 2, dans lequel un étrier est prévu pour fixer la position de la carte imprimée multicouche par rapport au plan de la carte imprimée principale.

4. Arrangement de relais selon l'une des revendications 1 à 3, dans lequel les premières bornes des relais sont formées par des bornes des relais qui sont réalisées avec une section de conducteur plus grande que les deuxièmes bornes et qui sont reliées directement à un contact de travail fixe du relais.

5. Arrangement de relais selon l'une quelconque des revendications précédentes, dans lequel la carte imprimée multicouche comprend au moins une couche de cuivre centrale et deux couches de cuivre extérieures entourant la couche de cuivre centrale, la couche de cuivre centrale étant reliée à un dispositif de mesure et les couches de cuivre extérieures étant reliées à la même des premières bornes.

6. Arrangement de relais selon la revendication 5, dans lequel un potentiel intermédiaire entre les au moins deux relais montés en série est déterminé sur la couche de cuivre centrale au moyen du dispositif de mesure.

7. Dispositif de conversion comprenant plusieurs ponts onduleurs et un arrangement de relais selon l'une des revendications précédentes comme point de coupure du réseau.

8. Dispositif de conversion selon la revendication 7, dans lequel des courants d'une phase des plusieurs ponts d'onduleurs sont conduits respectivement individuellement par des contacts de relais des au moins deux relais montés en série et sont réunis à l'une des deuxièmes connexions des au moins deux relais montés en série pour former une connexion de phase commune.

9. Dispositif de conversion selon la revendication 8, dans lequel les courants d'une phase de la pluralité de ponts onduleurs passent par différents contacts de relais du même relais.

10. Dispositif de conversion selon la revendication 8, dans lequel les courants d'une phase de la pluralité de ponts onduleurs passent par des contacts de relais différents.
